# EUROPEAN PATENT APPLICATION

(11) **EP 4 589 629 A2**
(43) Date of publication of application: **23.07.2025**
(21) Application number: 25176844.6
(22) Date of filing: 15.05.2025
(51) Int. Cl.: H01J 37/26

(54) **ASSESSMENT APPARATUS AND METHOD FOR ASSESSMENT**

(71) Applicant: ASML Netherlands B.V., 5500 AH Veldhoven (NL)
(72) Inventor: VAN WEPEREN, Ilse, 5500 AH Veldhoven (NL); GOOSEN, Maikel, Robert, 5500 AH Veldhoven (NL); ALMASI, Attaallah, 5500 AH Veldhoven (NL); BOSCH, Niels, Johannes, Maria, 5500 AH Veldhoven (NL)
(74) Representative: ASML Netherlands B.V.

(57) **Abstract**

An assessment apparatus for assessing a sample, the assessment apparatus comprising:
a sample holder for holding the sample;
an electron-optical device for directing a charged particle beam on to the sample; and
a detector module for detecting signal particles from the sample in response to the charged particle beam;
wherein the electron-optical device comprises a quantum sensor (301, 302, 310, 320) configured to measure a physical field in the assessment apparatus.

## Description

### FIELD

The present invention relates to assessment apparatus and methods, in particular assessment apparatus using charged particle beams for inspecting samples.

### BACKGROUND

During manufacturing processes of, for example, semiconductor integrated circuit (IC) chips or displays, undesired defects may occur on a substrate (e.g. wafer or a mask). Such defects may reduce yield. Defects may occur as a consequence of all kinds of processing necessary to produce an integrated circuit or display, for example, lithography, etching, deposition or chemical mechanical polishing. Defects may include patterning defects, in which the created pattern lies outside the pattern tolerance for the process, and particles. Monitoring the extent of defects during the manufacturing processes is therefore important. Such monitoring (or more generally assessment) includes the determination of the existence of a defect, but also the classification of the types of defects found.

For the assessment of a sample, different types of inspection or metrology systems have been used, including charged particle systems such as electron microscopes. Such assessment for inspection may relates to defects, for example the existence and classification of such defects. Electron microscopes typically generate a probe beam (also often referred to as primary beam) which may, for example, be scanned across a part of the substrate (such as in a scanning electron microscopes (SEM)). Collecting interaction products that result from the interaction of the primary beam with the part of the substrate, allows the electron microscope to collect data representing the probed part of the substrate. The data may be processed/rendered for example by the electron microscope to generate an image representation of the part of the substrate. The collected data for example as a generated image representation allows for measuring structures on the part of the substrate, or allows for identifying defective structures by comparing the image representation with a reference. Such measurement may be referred to as metrology; the identification of defective structures may be referred to as (defect) inspection. The interaction products may contain charged particles which may be referred to as signal particles (e.g. signal electrons), such as secondary electrons and backscattered electrons, and may contain other interaction products, such as X-ray radiation and even light.

In view of the continuing trend in the semiconductor industry to manufacture ever smaller and ever more complex devices, it is desirable to improve the assessment tools that are used to inspect devices during the manufacturing process. In particular it is desirable to monitor the stability of scanning electron microscopes that are used for device assessment without reducing throughput.

### SUMMARY OF INVENTION

It is an aim of the invention to address at least one deficiency of the prior art, in particular to improve precision and/or accuracy of a scanning electron microscope.

According to an aspect of the invention, there is provided an assessment apparatus for assessing a sample, the assessment apparatus comprising:
a sample holder for holding the sample;
an electron-optical device for directing a charged particle beam on to the sample; and
a detector module for detecting signal particles from the sample in response to the charged particle beam;
wherein the electron-optical device comprises a quantum sensor configured to measure a physical field in the assessment apparatus.

According to another aspect of the invention, there is provided an assessment method comprising:
directing a charged particle beam to a sample using an electron-optical device;
using a quantum sensor located in the electron-optical device to measure a physical field, e.g. an electrical or magnetic field.

### BRIEF DESCRIPTION OF THE DRAWINGS

Embodiments of the invention will now be described, by way of example only, with reference to the accompanying schematic drawings, in which:
Figure 1 is a schematic diagram of an exemplary assessment apparatus;
Figure 2 schematically depicts a multi-beam charged particle-optical device, for example of the assessment apparatus of Figure 1;
Figure 3 schematically depicts a multi-beam charged particle-optical device, for example of the assessment apparatus of Figure 1;
Figure 4 schematically depicts an alternative multi-beam charged particle-optical device, for example of the assessment apparatus of Figure 1;
Figure 5 schematically depicts a single beam charged particle-optical device, for example of the assessment apparatus of Figure 1;
Figure 6 schematically depicts the principle of operation of an atomic vapor cell usable in embodiments of the invention; and
FIG. 7 schematically depicts the principle of operation of a nitrogen-vacancy diamond sensor usable in embodiments of the invention.

The Figures are schematic. Within the following description of drawings, the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to with reference to electrons, throughout the present document may therefore be more generally be considered to be references to charged particles, and items referred to in reference to charged particles, with the charged particles not necessarily being electrons. For example, references to an electron-optical device may more generally be considered to be references to a charged particle-optical device.

### DETAILED DESCRIPTION

There is a trend in the semiconductor industry (often known as "Moore's law") to reduce the physical dimensions of structures representing circuit components on a substrate and/or to increase the packing density of such structures, in order to reduce the physical size of electronic devices and/or enhance the computing power of electronic devices. The physical dimensions of such structures may be reduced and/or the packing density of such structures may be increased by increasing lithographic resolution. Manufacturing processes of semiconductor IC chips can have 100s of individual steps. An error in any step of the manufacturing process has the potential to adversely affect the functioning of the electronic device. It is desirable to improve the overall yield of the manufacturing process. For example, to obtain a 75% yield for a 50-step manufacturing process (where a step may indicate the number of layers formed on a substrate), each individual step must have a yield greater than 99.4%. If an individual step has a yield of 95%, the overall yield of the manufacturing process would be as low as 7.7%. It is desirable to determine defects quickly so as to maintain a high substrate throughput, defined as the number of substrates processed per hour.

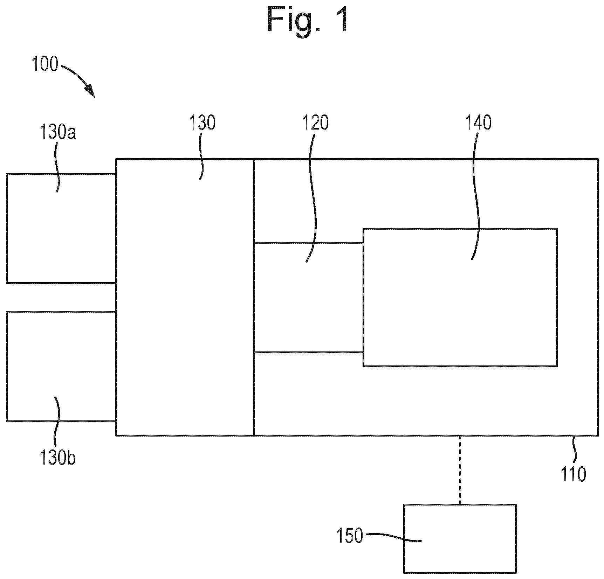

Figure 1 is a schematic diagram illustrating an exemplary assessment apparatus 100, e.g. a metrology apparatus or an inspection apparatus. The assessment apparatus 100 may be configured to scan a sample with one or more beams of electrons. The sample may be a semiconductor substrate, a substrate made of other material, or a mask, for example. The electrons interact with the sample and generate interaction products. The interaction products comprise signal electrons, e.g. secondary electrons and/or backscattered electrons, and possibly X-ray radiation. The assessment apparatus 100 may be configured to detect the interaction products from the sample so that a data set may be generated which may be processable into an image or any other data representation of the scanned area of the sample. For clarity, the description below focuses on embodiments in which the interaction products that are detected are signal electrons. The assessment apparatus 100 may comprise, for example during operation, a single beam or a plurality of beams, i.e. a multi-beam. The component beams of a multi-beam may be referred to as sub-beams or beamlets. A multi-beam may be used to scan different parts of a sample simultaneously. When the assessment apparatus 100 uses a multi-beam, the assessment apparatus 100 may assess a sample more quickly than when the assessment apparatus 100 uses a single-beam. For example, a higher throughput of sample assessment may be achieved using a multibeam assessment apparatus compared to a single beam apparatus.

The assessment apparatus 100 of Figure 1 comprises a vacuum chamber 110, a load lock chamber 120, an electron-optical apparatus 140, an equipment front end module (EFEM) 130 and a controller 150. The electron-optical apparatus 140 (also known as an electron beam apparatus or an electron apparatus) may be within the vacuum chamber 110. The electron-optical apparatus 140 may comprise an electron-optical device (described in more detail below) and an actuatable stage. It should be appreciated that reference in the description to the electron-optical elements of the electron-optical apparatus 140 can be considered to be a reference to the electron-optical device.

The EFEM 130 includes a first loading port 130a and a second loading port 130b. The EFEM 130 may include additional loading port(s). The first loading port 130a and the second loading port 130b may, for example, receive substrate front opening unified pods that contain samples. One or more robot arms (not shown) in the EFEM 130 transport the samples to the load lock chamber 120.

The load lock chamber 120 is used to remove the gas around a sample. The load lock chamber 120 may be connected to a load lock vacuum pump system (not shown), which removes gas particles in the load lock chamber 120. The operation of the load lock vacuum pump system enables the load lock chamber to reach a first pressure below the atmospheric pressure. The vacuum chamber 110, which may be a main chamber of the assessment apparatus 100, is connected to a main chamber vacuum pump system (not shown). The main chamber vacuum pump system removes gas molecules from the vacuum chamber 110 so that the pressure around the sample reaches a second pressure equal to or lower than the first pressure. Different parts of the electron-optical apparatus 140 may have different levels of pressure below the atmospheric pressure. After reaching the required pressure, the sample leaves the load lock chamber 120 and is transported to the electron-optical apparatus 140 by which it may be assessed. The electron-optical apparatus 140 may use either a single beam or a multi-beam for the assessment. Alternatively, an electron-optical device array comprising a plurality of electron-optical devices may be used, further also referred to as a multi-column electron-array, in which each electron-optical device (or each column in the multi-column array) comprises, for example during operation, either a single beam or a multi-beam.

The controller 150 is electronically connected to the electron-optical apparatus 140. The controller 150 may be a processor (such as a computer) configured to control the assessment apparatus 100. The controller 150 may also include processing circuitry configured to execute data, signal and image processing functions for example on the data set e.g. embodied as signals such as detection signals. The controller 150 may thus include processing circuitry configured to execute processing functions on signal, image and other data produced in the assessment apparatus 100. While the controller 150 is shown in Figure 1 as being outside of the structure that includes the vacuum chamber 110, the load lock chamber 120, and the EFEM 130, it is appreciated that the controller 150 may be part of the structure. The controller 150 may be located in one of the components of the assessment apparatus 100 or it may be distributed over at least two of the components.

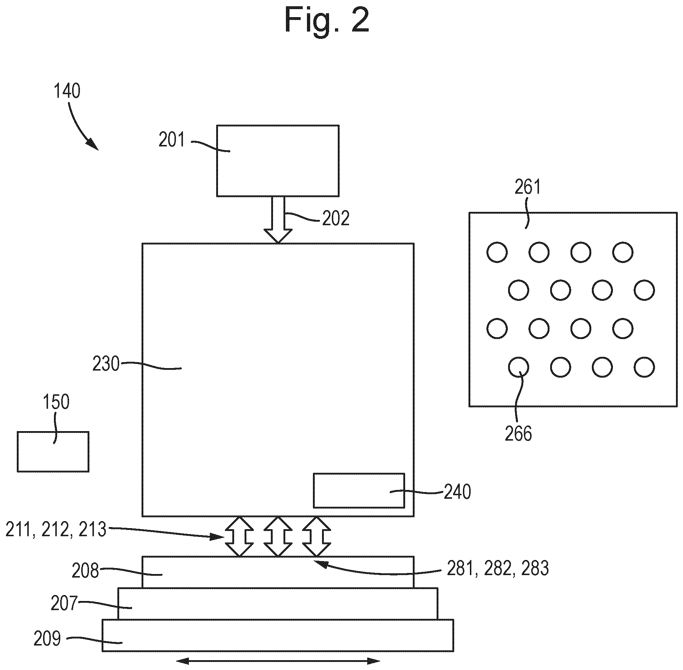

Figure 2 is a schematic diagram illustrating an exemplary electron-optical apparatus 140. The electron-optical apparatus 140 may be provided as part of the assessment apparatus 100 of Figure 1. The electron-optical apparatus 140 includes a source 201 and an electron-optical device 230 (which may also be referred to as an electron-optical column). The source 201 may comprise a cathode (not shown) and an extractor and/or anode (not shown). During operation, the source 201 is configured to emit electrons from the cathode. The electrons may be extracted or accelerated by the extractor and/or the anode to form the source beam 202.

The electron-optical device 230 may be configured to convert the source beam 202 into a plurality of primary beams 211, 212, 213 (which may be referred to as sub-beams or beamlets). The electron-optical device 230 may be configured to direct the primary beams 211, 212, 213 along respective beam paths toward a sample location for the sample 208. Although three beams are illustrated, the number of beams may be of the order of 100s or 1,000s, for example up to 20,000 per electron-optical apparatus 140. The plurality of beams may be referred to collectively as a multi-beam or a beam grid. The different beams may be arranged relative to each other across the beam grid in a pattern. The pattern of the beam grid may be referred to as an array. The electron-optical device 230 has a field of view which may be defined as the area of the surface of the sample 208 within which the primary beams 211, 212, 213 can scan while the aberrations of the electron-optical device 230 remain within a defined value. Alternatively, the field of view may be defined by the maximum scan range of the electron-optical device 230. The field of view may be of the order of millimetres, for example up to 20mm at the sample 208.

The electron-optical device 230 comprises a plurality of electron-optical elements positioned along the beam paths. The electron-optical elements are configured to manipulate the beams. For example, the electron-optical elements may be configured to lens, focus, deflect or correct the beams. The electron-optical elements may be arranged in at least one stack of electron-optical elements. Such an electron-optical element may be positioned upbeam or downbeam with respect to another of the electron-optical elements. The terms upbeam and downbeam relate to the direction of the beams from the source 201 to the sample 208 during use of the electron-optical device 230, which may be expressed as a direction along one or more of the beam paths. In an embodiment some of the different electron-optical elements may take a planar form, such as a plate 261. An electric field that manipulates the beams may be generated between two plates 261, e.g. by applying, in use, different potentials to neighboring/adjoining plates 261 such as along the beam path. An electric field that manipulates the beams may be generated between surfaces of plates 261 across the beam path for example between the neighboring plates 261. One or more beam apertures 266 may be defined in the plates 261 for the passage of one or more beams. The beam apertures 266 may be arranged in a pattern such as a regular grid e.g. hexagonal or square. Such a pattern of the beam apertures 266 may be referred to as an aperture array (i.e. a two-dimensional array over the surface of the plate). The pattern of the beam apertures 266 may correspond to the pattern of beams within the beam grid. Beam apertures 266 in different plates operating on the same beam(s) are typically aligned.

The electron-optical elements may comprise one or more corrector arrays. For example, a corrector array may be integrated into the shape, position and/or size of the beam apertures 266 of the plates 261. The disclosure of such a corrector array as described in WO 2022101072 A1 is hereby incorporated by reference. One or more corrector arrays may comprise multipole deflectors with a specific superposition of potentials applied across the individually controllable electrodes. The disclosure in WO2012165955 of an array of multipole deflectors is hereby incorporated by reference.

One or more of the electron-optical elements may comprise an aperture for the path of a plurality of the beams. For example, the aperture may be a macro aperture for all of the beams. The disclosures of a slit aperture for a collimator or corrector comprising strip electrodes in WO 2021156121 A1 and WO 2021204734 A1 are hereby incorporated by reference. One or more electron-optical elements may comprise one or more plate electrodes that are curved across the path of the beam grid for use as a lens array, a corrector array and/or a collimator array such as disclosed in European patent application 23211553.5 filed 22 November 2023, which is hereby incorporated by reference at least so far as the use and application of curved plate electrodes.

In the current embodiment, the electron-optical device 230 may form three probe spots 281, 282, 283 on the surface of the sample 208. The electron-optical device 230 may be configured to deflect the primary beams 211, 212, 213 so as to scan the probe spots 281, 282, 283 across individual scanning areas of the sample 208. In response to incidence of the primary beams 211, 212, 213 on the sample 208, signal electrons are generated from the sample 208, which may include secondary electrons and backscattered electrons. Secondary electrons typically have electron energy of at most 50 eV. Backscattered electrons typically have electron energy of more than 50 eV and less than the landing energy of the primary beams 211, 212, 213.

The electron-optical apparatus 140 comprises a sample holder 207 that supports a sample 208. The sample holder 207 supports the sample 208 for assessment. The sample holder 207 is supported by an actuatable stage 209. The electron-optical apparatus 140 further comprises a detector array 240. The detector array 240 may be part of the electron-optical device 230. The detector array 240 e.g. detects signal electrons from the sample 208. The detector array 240 generates detection signals based on detection of the signal electrons.

In an embodiment, the detector array 240 may define the surface of the electron-optical apparatus 140 facing the sample 208, e.g. the bottom surface of the electron-optical device 230. There may be more than one detector array at different positions along the paths of the primary beams 211, 212, 213.

The detector array 240 may comprise a plurality of detector elements, with at least one detector element per beam. The detector elements may, for example, be charge capture electrodes, for example metal plates, which may be configured to detect at least some of the signal electrons. Alternatively or additionally, the detector elements may comprise detection diodes configured to detect at least some of the signal electrons. Alternatively or additionally, the detector elements may comprise a scintillator material (such as YAG) configured to convert signal electrons into photons that may be subsequently detected. The detector elements may be arranged around beam apertures 266 in the bottom surface of the electron-optical device 230 to allow the primary beams 211, 212, 213 to pass towards the sample 208. Each detector element may comprise a plurality of detection segments or may constitute a single sensitive surface for each beam. The detection signal generated by a detector element may be transmitted to a processor for generation of an image. For example, the detection signal may represent a grey value or an intensity value of a pixel of an image.

The detector array 240 may send the detection signals, for example as an imaging signal or a detection signal, to the controller 150 or to a signal processing system (not shown) which may be part of the controller 150. The controller 150 or the signal processing system may be configured to generate images of the corresponding scanned areas of the sample 208. The detector array 240 may be incorporated at least partly into the electron-optical device 230. Alternatively, the detector array 240 may be separate from the electron-optical device 230. For example, the electron-optical apparatus 140 may comprise a secondary electron-optical device configured to direct secondary electrons to the detector array 240. In such an embodiment, the secondary electron-optical device comprises a beam separator (such as a Wien filter, not shown). The beam separator may separate the paths of the primary electrons towards the sample 208 from the paths of the signal electrons away from the sample 208. Note, such a beam separator may be present in a different embodiment with a detector array within the electron-optical device 230 for directing the primary electrons towards the sample and the signal particles to detector elements of the detector array.

The controller 150 (for example a control system comprising distributed controllers) may be connected to various parts (e.g. components) of the electron-optical apparatus 140 of Figure 2, such as the source 201, the detector array 240, the electron-optical device 230, and the actuatable stage 209. The controller 150 may perform various image processing functions and signal processing functions. The controller 150 may also generate various control signals to govern operations of the assessment apparatus 100.

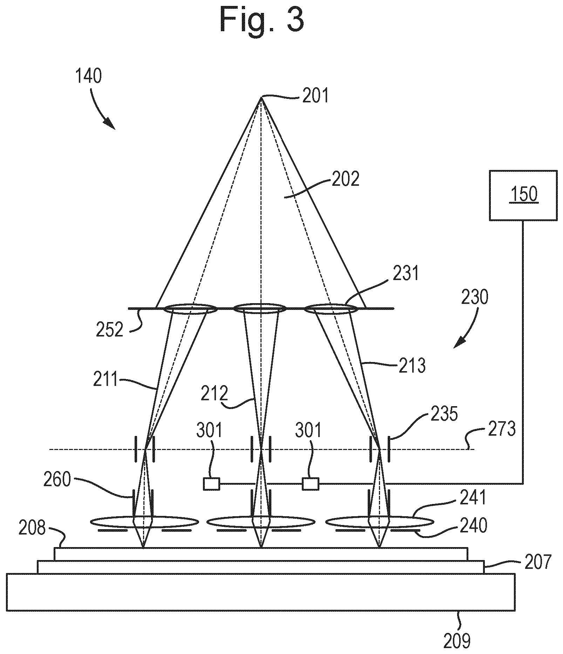

Figure 3 schematically depicts an electron-optical apparatus 140 of an assessment apparatus, e.g. the assessment apparatus 100 of Figure 1. The electron-optical apparatus 140 of Figure 3 may be the electron-optical apparatus 140 of Figure 2 in which the electron-optical elements of the electron-optical device 230 comprise a beam limiting aperture array 252, a condenser lens array 231, a collimator array 271 desirably at an intermediate focus plane 273, a scan deflector array 260, an objective lens array 241 and the detector array 240.

The source 201 generates a diverging source beam 202. The beam limiting aperture array 252 defines a plurality of primary beams 211, 212, 213 from the source beam 202. The condenser lens array 231 focuses the primary beams 211, 212, 213 at the intermediate focus plane 273. The condenser lens array 231 may comprise the beam limiting aperture array 252. Alternatively, the condenser lens array 231 may be downbeam of the beam limiting aperture array 252. The condenser lens array 231 may be electrostatic. In an alternative embodiment the condenser lens array 231 comprises a magnetic element for example as a plurality of magnetic elements / one or more magnetic elements.

The collimator array 271 is configured to collimate the primary beams 211, 212, 213 along respective beam paths towards and substantially orthogonal to a surface of the sample 208. The collimator array 271 may be located at or near the intermediate focus plane 273. The collimator array 271 may comprise a plurality of deflectors configured to deflect respective primary beams 211, 212, 213. Additionally or alternatively the collimator array 271 may comprise a lens array that operates on the different beams to deflect the relative paths of the beams. The collimator array 271 may be electrostatic. The collimator array 271 may consist of a single plate 261 comprising electrodes around the beam apertures 266, such as on the surface around the beam apertures 266 and/or on the inside of the beam apertures 266. The electrodes may cooperate as a deflector per beam aperture 266. Alternatively, the collimator array 271 may comprise a stack of plates 261. In use a potential difference is applied between the plates 261 so as to generate a lensing effect at the beam apertures 266. The plates 261 may have a curvature across the beam path. Alternatively, the collimator array 271 may comprise a plurality of layers of strip electrode deflectors as shown in WO2021156121 and WO2021204734. A layer of strip electrode deflectors may consist of a plate. Although not shown in Figure 3, in an alternative embodiment the collimator array 271 is replaced by a macro collimator configured to collimate the primary beams 211, 212, 213. The macro collimator may be a magnetic lens, or an electrostatic lens, or a combination of magnetic and electrostatic lens. In a further alternative embodiment, the electron-optical device 230 comprises a macro collimator in addition to the collimator array 271.

The deflectors of the scan deflector array 260 may be formed at apertures of the scan deflector array 260. The deflectors may comprise respective sets of individually controllable electrodes. Such a deflector may be referred to as a multipole deflector. The individually controllable electrodes extend partially along the beam path of the respective beam. The individually controllable electrodes may be controlled to generate, in use, a scan movement of the respective beam across the sample 208. Typically, the sets of individually controllable electrodes operate to scan all of the primary beams 211, 212, 213 simultaneously in parallel across the individual fields of view of the respective objective lenses of the objective lens array 241. Alternatively, the scan deflector array 260 may comprise strip deflectors (as shown in WO2004081910, WO2021156121 and WO2021204734) configured to deflect a row of beams along the individual fields of view of the respective objective lenses of the objective lens array 241.

The objective lens array 241 is configured to focus the primary beams 211, 212, 213 onto the sample 208. The objective lens array 241 may comprise a stack of plates 261. Different potentials are applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The stack of plates 261 of the objective lens array 241 may be referred to as, or as part of, an objective lens assembly. The objective lens assembly may comprise one or more of the scan deflector array 260, a corrector array (not shown) and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, a condenser lens array, a collimator array, an objective lens array and a detector array are hereby incorporated by reference.

The electron-optical device 230 may comprise one or more corrector arrays configured to at least partly correct one or more types of aberration of the beams. Such corrector arrays may be associated with or integrated into the condenser lens array 231, the collimator array 271 and/or the objective lens array 241, or between two of these arrays, e.g. between the condenser lens array and the collimator array.

The electron-optical apparatus 140 of Figure 3 also includes electromagnetic sensors 301 that are connected to controller 150. The electromagnetic sensors 301 are described further below. Electromagnetic sensors 301 may be magnetometers.

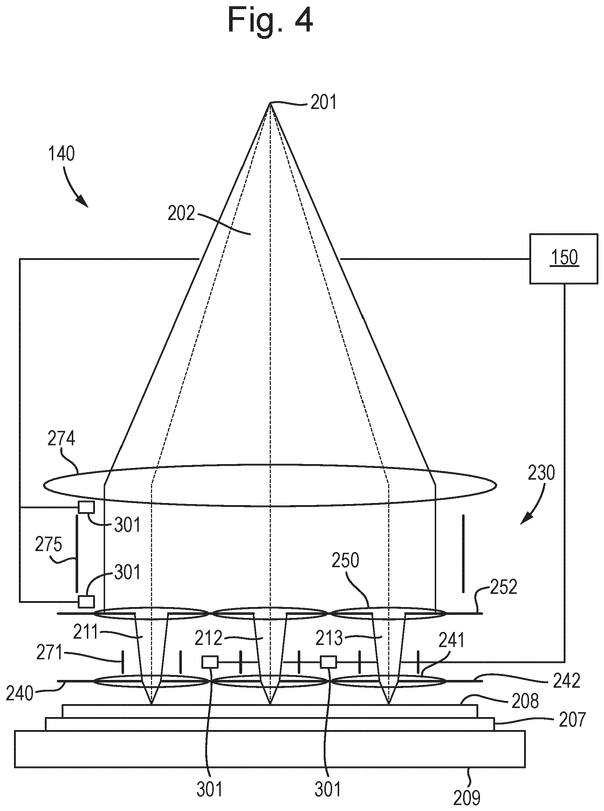

Figure 4 schematically depicts an electron-optical apparatus 140 of an assessment apparatus, e.g. the assessment apparatus 100 of Figure 1. The electron-optical apparatus 140 of Figure 4 may be the electron-optical apparatus 140 of Figure 2 in which the electron-optical device 230 comprises a macro condenser lens 274, a macro scan deflector 275, a beam limiting aperture array 252 (which may be referred to as an upper beam limiter), a control lens array 250, a collimator array 271, an objective lens array 241, a beam shaper array 242 (which may be referred to as a lower beam limiter) and the detector array 240.

The source 201 generates a diverging source beam 202. The macro condenser lens 274 is located between the source 201 and the objective lens array 241. The macro condenser lens 274 is configured to at least partly collimate the source beam 202. The macro scan deflector 275 is located between the macro condenser lens 274 and the objective lens array 241. The macro scan deflector 275 is configured to operate on the source beam 202 so that the primary beams 211, 212, 213 scan the surface of the sample 208. Additionally or alternatively the electron-optical device 230 may comprise a scan deflector array (not shown) downbeam of the control lens array 250. The macro condenser lens 274 and/or the macro scan deflector 275 may at least in part be magnetic.

The beam limiting aperture array 252 defines a plurality of primary beams 211, 212, 213 from the source beam 202. The beam shaper array 242 and the beam limiting aperture array 252 are plates 261 in which the beam apertures 266 are smaller in dimension than other plates of the electron-optical device 230. The beam apertures 266 of the beam limiting aperture array 252 define the primary beams 211, 212, 213. The beam apertures 266 of the beam shaper array 242 shape the primary beams 211, 212, 213 to at least partially correct for types of aberration in the beams.

The collimator array 271 is configured to collimate the primary beams 211, 212, 213 along respective beam paths towards and substantially orthogonal to a surface of the sample 208. The collimator array 271 may be located between the beam limiting aperture array 252 and the objective lens array 241. The collimator array 271 may be omitted. Alternatively, when the collimator array 271 is provided, then the macro condenser lens 274 may be omitted. The collimator array 271 may comprise a plurality of deflectors configured to deflect respective primary beams 211, 212, 213. The collimator array 271 may be electrostatic. The collimator array 271 may consist of a single plate 261 comprising the deflectors around the beam apertures 266, for example on the surface around the beam apertures 266 and/or on the inside of the beam apertures 266. Alternatively, the collimator array 271 may comprise a stack of plates 261. In use a potential difference is applied between the plates 261 so as to generate a lensing effect at the beam apertures 266. One or more of the plates may be curved across the path of the beam grid. Alternatively or additionally, the collimator array 271 may comprise a plurality of layers of strip electrode deflectors. A layer of strip electrode deflectors may be a plate.

The objective lens array 241 is configured to focus the primary beams 211, 212, 213 onto the sample 208. The objective lens array 241 may comprise a stack of plates 261. In use, different potentials may be applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The control lens array 250 may be upbeam of the objective lens array 241. The control lens array 250 may comprise a stack of plates 261, for example at least three plates 261. The control lens array 250 may be configured to control electron-optical parameters of the primary beams 211, 212, 213. In an embodiment, the most downbeam plate of the control lens array 250 is the most upbeam plate of the objective lens array 241. Alternatively, the control lens array 250 may be considered to be part of the objective lens array 241. The control lens array may provide one or more additional degrees in electron-optical freedom such as in pre-focusing, magnification and beam current setting.

The stack of plates 261 of the objective lens array 241 may be referred to as an objective lens assembly. The objective lens assembly may comprise one or more of the beam limiting aperture array 252, the control lens array 250, a corrector array (not shown), the collimator array 271, the beam shaper array 242 and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, an objective lens array and a detector array are hereby incorporated by reference. The disclosure in WO2022058252 A1 of the collimator array, the macro condenser lens, the macro scan deflector, and the need for a beam limiting aperture array and a beam shaper array is incorporated by reference.

The electron-optical device 230 may comprise one or more corrector arrays (not shown) configured to at least partly correct one or more types of aberration of the beams. Such corrector arrays may be associated with or integrated into the control lens array 250, the collimator array 271 and/or the objective lens array 241, for example as part of the objective lens assembly.

The electron-optical device 140 of Figure 4 also includes electromagnetic sensors 301, 302 that are connected to controller 150. The electromagnetic sensors 301, 302 are described further below. Electromagnetic sensors 301 may be magnetometers and Electromagnetic sensors 302 may be electrometers.

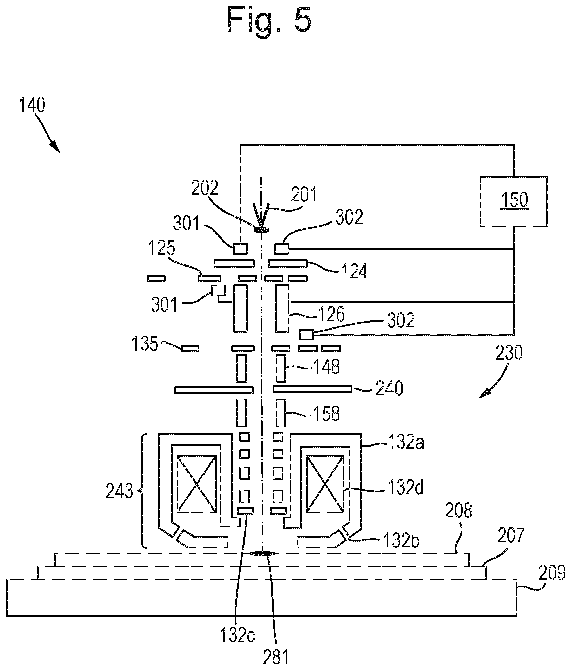

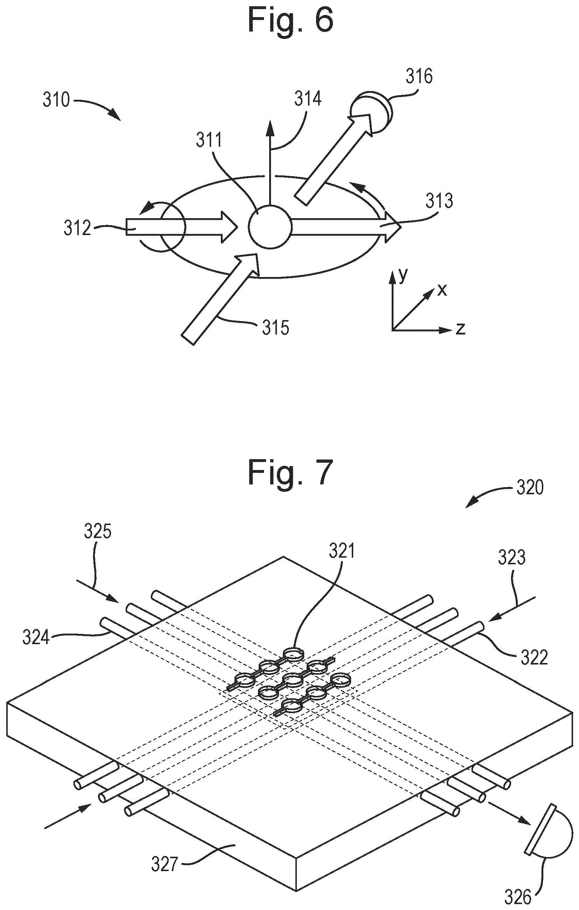

Figure 5 schematically depicts an electron-optical apparatus 140 of an assessment apparatus, e.g. the assessment apparatus 100 of Figure 1. As shown in Figure 7, in an embodiment the electron-optical apparatus 140 comprises an electron-optical device 230 that comprises a beam limit aperture 125 (the image actually shows an array of selectable beam limiting apertures), a condenser lens 126, a column aperture 135 (again indicated as an array of selectable column apertures 135), an objective lens 243 and a detector array 240.

The source 201 is configured to generate a source beam 202. A gun aperture 124 blocks peripheral electrons of the source beam 202. The source beam 202 passes through the beam limit aperture 125, the condenser lens 126 and the column aperture 135. The condenser lens 126 may be magnetic, electrostatic or a combination of magnetic and electrostatic.

In an embodiment the electron-optical device 230 comprises electromagnetic multipole, e.g. quadrupole, electron lenses. For example, the electron-optical device 230 may comprise a first multipole lens 148 and a second multipole lens 158. In an embodiment, the first multipole lens 148 and the second multipole lens 158 are used for controlling the source beam 202. For example, the first multipole lens 148 may be configured to adjust the beam current of the source beam 202. The second multipole lens 158 may be configured to adjust the size of the probe spot 281 and/or the shape of the source beam 202.

The objective lens 243 focuses the source beam 202 onto the sample 208. In an embodiment the objective lens 243 comprises a pole piece 132a, a control electrode 132b, a deflector 132c and an exciting coil 132d. In an embodiment a deflector, such as the deflector 132c or other deflectors in the objective lens 243 are configured to scan the source beam 202 across the surface of the sample 208. The detector array 240 is configured to detect signal electrons from the sample 208.

The electron-optical apparatus 140 of Figure 5 also includes electromagnetic sensors 301, 302 that are connected to controller 150. The electromagnetic sensors 301, 302 are described further below. Electromagnetic sensors 301 may be magnetometers and Electromagnetic sensors 302 may be electrometers.

It is desirable to monitor physical fields, e.g. electric fields and magnetic fields in an assessment apparatus using a charged particle beam or beams. Electric and magnetic fields may affect the trajectories of charged particles, both in the incident charged particle beam and the returning signals. Unintended variation in the electric or magnetic fields in the vicinity of the beam paths may therefore affect the assessment result, for example by distorting an image of the sample due to unintended deflection of the charged particles.

Electric and/or magnetic fields in the assessment apparatus may vary because of variations in the environmental magnetic field, due to tolerances in the assessment apparatus or due to various aging processes. The electric and/or magnetic field at specific points in the assessment apparatus may also vary due to the movement of the parts of the assessment apparatus, such as the actuatable stage. Ion pumps, which are required to maintain a vacuum in the assessment apparatus, may also cause magnetic field disturbances. It has been proposed to use a flux gate in research and development settings to investigate the performance of components of an electron-optical device but flux gates are too bulky for use in a fully assembled production assessment apparatus.

Quantum sensors, in particular atomic vapor cells and nitrogen-vacancy diamond sensors can be used in assessment apparatuses to measure physical fields, e.g. electric and/or magnetic fields. Quantum sensors can meet the exacting requirements for this purpose: being small enough to be locatable between components and close to beam paths whilst also sensitive enough to provide useful and accurate measurements. Advantageously, quantum sensors do not exhibit 1/f noise. A particular advantage of atomic vapor cells and nitrogen-vacancy diamond sensors is that they can be driven and read optically, avoiding the need for electrical connections which might both disturb and be disturbed by electrical and magnetic fields in the assessment apparatus.

Figure 6 depicts an atomic vapor cell 310 that can be used in embodiments of the invention as a magnetometer (that is to measure magnetic fields). The atomic vapor cell 310 consists of a sealed vessel 311 containing a gas of atoms, typically rubidium (Rb) or cesium (Cs), at very low pressure. Circularly polarised pump light 312 is directed onto the gas and causes the atomic spins of the gas to align in the direction 313. The magnetic field 314 causes the atomic spins to precess. Linearly polarised detection light 315 (sometimes referred to as probe light) is directed through the vessel 311 perpendicularly to pump light 312. The polarization of detection light 315 is rotated by an amount dependent on the magnitude of magnetic field 314, which can be detected by analyser 316. In other arrangements, the magnetic field can be detected based on detecting changes in the polarization of a single light beam that is passed through the gas.

Figure 7 depicts a nitrogen-vacancy diamond sensor 320 that can be used in embodiments of the invention as a magnetometer (that is to measure magnetic fields). The nitrogen-vacancy diamond sensor 320 comprises a diamond substrate 321 containing nitrogen-vacancy centres. Pump fibres 322 direct pump light 323, for example at 532 nm, to the nitrogen-vacancy centres. Intersecting measurement fibres 324 direct infra-red measurement light 325, for example at 1042 nm, through the nitrogen-vacancy centres to infra-red detector 326. Microwave inductor lines (not shown in the figure) provide a microwave background field. The absorption of the infra-red measurement light 325 is dependent on the magnetic field to be measured and the frequency of the microwave field. The magnetic field can be measured at different locations by selective energisation of the pump light and measurement light in different ones of the pump fibres and measurement fibres, for example using multiplexed laser sources. The diamond substrate 321 may be embedded in a polymer platform 327, which may be formed on a silicon substrate (not shown) or other carrier.

Another type of nitrogen-vacancy diamond sensor that can be used in embodiments of the invention uses pump light to excite the NV centre and directly measures emitted fluorescence light, omitting the measurement light.

Nitrogen-vacancy diamond sensors can also be configured to measure the electric field or both the electric and magnetic fields.

Nitrogen-vacancy diamond sensors can be made smaller than atomic vapor cells and although may have lower sensitivity can be applicable in cases where there is less available space or it is advantageous to be close to the point of interest.

In embodiments of the invention, quantum sensors may be located at various positions with an assessment apparatus to address specific sources of disturbance to the electric and magnetic fields in the assessment apparatus as discussed below. An assessment apparatus may have quantum sensors at any or all of the locations discussed below and synergistic effects may arise from specific combinations of quantum sensors in specific locations. In general, magnetometers can be used to measure the (stability of) magnetic lenses and moving electrons; electrometers to measure the (stability of) electrostatic column elements, unintended charging of column elements and moving electrons. Monitoring of the magnetic field (B-field) of electron-optical elements in the column during operation of the tool enables information relating to drift of electron-optical elements to be obtained, which e.g. allows for planning of maintenance actions or adjustment of the excitation of the element (e.g. in a feedback loop).

In each location mentioned below, it is possible to provide multiple scalar magnetometers with different (for example orthogonal) orientations to determine the magnetic field strength in two or three dimensions with high accuracy. In other cases, a vector magnetometer may be more convenient but may have lower sensitivity than scalar magnetometers.

In a single beam electron-optical device, such as shown in Figure 5, one or more quantum sensors 301 configured to act as magnetometers and/or one or more quantum sensors 302 configured to act as electrometers may be located in the vicinity of source 201 for beam current emission sensing. These quantum sensors can sense (variations in) the beam current emission profile (for example, magnitude and/or angular spread). Such information allows for planning of maintenance actions, adjustment of the tip operating conditions (e.g. current through the tip, operating temperature) or adjustment of tool imaging settings (e.g. more frame averaging if tip instability is observed). Adjustment of tip operating conditions may be part of a feedback or feedforward control loop.

One or more quantum sensors 301 configured to act as magnetometers may be located near condenser lens 126 for sensing condenser lens stability and/or near the objective lens 243 for sensing objective lens stability.

One or more quantum sensors 302 configured to act as electrometers may be located in the vicinity of column aperture 135 (or other beam forming apertures) and/or detector array 240 for sensing charging of those components and/or near the deflector for sensing deflector stability.

A plurality of quantum sensors configured to measure magnetic fields and placed around the beam path(s), for example in a plane perpendicular to the beam paths, can be used to measure or map the current density of the charged particle beam(s). In particular in a multi-beam system, quantum sensors placed in between the charged particle beams can be used to measure differences in the beam current of the charged particle beams. Current density can also be measured using a single quantum sensor (or a few quantum sensors) that is moved around the charged particle beam(s), for example mounted on a rotating ring. Current density can be calculated by measuring long-range magnetic fields, also known as Oersted fields, that are created by moving charges according to the Biot-Savart law. The field measurements are used to determine the currents by numerically inverting the Biot-Savart law.

Two quantum sensors configured to measure magnetic fields, one placed adjacent the sample and one placed further up the electron-optical axis can be used to measure the signal from the sample. The sensor adjacent the sample measures the net current of the charged particle beam and the signal particles emitted from the sample whilst the one placed further up the electron-optical axis measures only the current of the charged particle beam so the current of the signal particles can be obtained by subtraction. Even if the quantum sensors do not have a high enough sampling rate for use in assessment, this arrangement can be useful for calibration of other types of detection.

Quantum sensors located close to the sample in a multi-beam assessment apparatus (as depicted in Figures 3 and 4) and configured to measure magnetic fields can be used to determine the magnetic field variation between sampling locations allowing for per-beam correction of the probe spot, reducing distortion of output images. Per-beam corrections can be performed by adjusting the voltages of the scan deflector array 260. It is also possible to adjust the macro collimator 270.

It is desirable that the quantum sensor has a sampling rate greater than 1 Hz and more desirably greater than (more desirably more than five times) the sampling rate of the assessment apparatus, for example 100 to 500 Hz. A sampling rate in this range is convenient to measure 50/60 Hz noise that may be present.

It is desirable that the quantum sensor has a sensitivity of less than 20 nT/sqrt(Hz) if measuring a magnetic field or less than 10 mV/m if measuring an electric field.

If the absolute value of the magnetic field to be measured is greater than the quantum sensor can measure, a local compensating field can be applied, for example by use of an electromagnet such as a Helmholtz coil, so that the net field is within the measurement range of the quantum sensor.

Advantages that can be achieved by embodiments of the invention include higher availability of an assessment apparatus due to monitoring of performance, giving early indications of drift and allowing (in some cases automated) adjustment of settings to avoid the assessment apparatus operating out of spec. Similarly, monitoring allows planned maintenance actions rather than waiting for the assessment apparatus to go out of spec. Additionally, faster identification of root-causes of faults or reduced performance can be achieved, reducing downtime. Another benefit of a more robust and stable assessment apparatus is that it allows for improved tool-to-tool matching. Instead of only comparing imaging performance of the assessment apparatuses, one can also directly compare their sensor data. In addition to robustness and stability, improved performance of the assessment apparatus due to monitoring of its performance can be achieved. If needed, adjustment of settings to maintain good imaging performance can be realized. Finally, faster set-up and qualification can be realized as adjustments can be guided by sensor data.

In an embodiment any electron-optical element or group of electron-optical elements may be replaceable or field replaceable within the electron-optical apparatus 140. Field replaceability means that the electron-optical element or group of electron-optical elements may be replaced without substantially disassembling the electron-optical apparatus 140. In an embodiment the electron-optical apparatus 140 comprises at least one module. Each module comprises a group of adjacent electron-optical elements. The electron-optical elements of a module may be secured to each other, for example as a stack. Electromagnetic sensors 301, 302 may be included in a replaceable module alone or along with other electron-optical elements.

Features in electron-optical plates may be manufactured using techniques from microelectromechanical systems (MEMS) (i.e. using MEMS manufacturing techniques). MEMS are miniaturized mechanical and electromechanical elements that are made using microfabrication techniques. Merely as an example, a collimator array may be formed using MEMS manufacturing techniques so as to be spatially compact. As another example, a scan deflector array may be formed using MEMS manufacturing techniques. Electromagnetic sensors 301, 302 may be manufactured using MEMS manufacturing techniques or integrated photonics techniques.

In an embodiment, the controller 150 is configured to control the electron-optical device 230. The controller 150 may be configured to control potentials applied to electrodes of lenses of the electron-optical device 230.

In an embodiment the controller 150 is configured to control the actuatable stage 209 to move the sample 208 during inspection of the sample 208. The controller 150 may enable the actuatable stage 209 to move the sample 208 in a direction, for example continuously, such as at a constant speed, at least during sample inspection, which may be referred to as a type of scanning. The speed of the actuatable stage 209 may be referred to as the moving rate. The controller 150 may control movement of the actuatable stage 209 so as to change the speed of movement of the sample 208 relative to the beam paths dependent on one or more parameters. The controller 150 may control deflection of scan deflectors so that the beam paths move relative to the actuatable stage 209 and thus over the surface of the sample 208. The controller 150 may change a beam deflection of a scan deflector and thus the scanning of the primary beams 211, 212, 213 over the sample 208 dependent on one or more parameters. For example, the controller 150 may control a scan deflector and/or the speed of the actuatable stage 209 and/or the direction of movement of the actuatable stage 209 depending on characteristics of the assessment process. The disclosure in EP4086933 A1 of a combined stepping and scanning strategy of the stage and scanning deflectors is hereby incorporated by reference. The moving rate may at different times comprise a stepping frequency and/or a stage scanning rate.

Signals from electromagnetic sensors 301, 302 are used by controller 150 in controlling various aspects of the electron-optical device 230, for example the moving rate or the beam deflection, to improve precision and/or accuracy of the assessment of the sample. The signals from electromagnetic sensors 301, 302 may be used in a feedback mode or a feedforward mode. In a feedback mode the signals from electromagnetic sensors 301, 302 are used to adjust parameters of the electron-optical device during the same assessment operation as the signals are obtained, for example during assessment of the same sample or same area of the sample. In a feedforward mode, the signals from electromagnetic sensors 301, 302 are used to adjust parameters of the electron-optical device during a future assessment operation, for example during assessment of the another sample or another area of the sample.

In feedback and feedforward modes, knowledge of electric and/or magnetic fields at one or more locations in the electron-optical device can be used to predict unintended deflections of the charged particle beam. Predictions of such unintended deflections can be used to determine compensating changes, for example a deviation in the path of the sample or a compensation deflection of the charged particle beam. Alternatively or in addition, a measurement of the electric and/or magnetic fields at one or more locations in the electron-optical device may provide information that a component of the electron-optical device is not operating as expected. In such a case, remedial action may include: adjusting the voltage(s) applied to such a component; adjusting the position of such a component or part thereof; replacing the component.

Alternatively or in addition, the signals from electromagnetic sensors 301, 302 are used in a post-processing step. For example, if the output of the assessment apparatus is an image of the sample, knowledge of the electric and/or magnetic fields at one or more locations in the electron-optical device can be used to correct or improve the image of the sample. If knowledge of changes in electric and/or magnetic fields at one or more locations in the electron-optical device during the scanning process is available, this can be used to apply different corrections to different parts of the image.

Post-processing is particularly useful for removal of 50/60 Hz noise that may manifest as image ripple. The sensor information can be correlated with detector signals and any correlation found removed, potentially based on a model of the effect of field fluctuation on output image.

Alternatively or in addition, the signals from electromagnetic sensors 301, 302 are used in a calibration mode. For example, the electron-optical device, or parts of it, may be energised and the electric and/or magnetic fields measured. If the results of the measurement are not as expected, the electron-optical device is adjusted, for example by changing voltage set-points or mechanical adjustment of parts. The measurement and adjustment steps are repeated until acceptable results are achieved. This approach can improve machine-to-machine matching.

Alternatively or in addition, the signals from electromagnetic sensors 301, 302 are used in a maintenance mode. The signals from electromagnetic sensors 301, 302 may provide information about drift or instability of components enabling determination or prediction of when maintenance is required. Maintenance actions may include adjustment of components of the assessment apparatus informed by information derived from the signals from electromagnetic sensors 301, 302, for example if an electric field is measured as being low, the related electrodes might be moved closer together. Maintenance may involve repair or replacement of components.

Although specific reference may be made in this text to embodiments of the invention in the context of an electron microscope, embodiments of the invention may be used in other types of apparatus. Embodiments of the invention may form part of a mask inspection apparatus, a metrology apparatus, or any apparatus that measures or processes an object such as a wafer (or other substrate) or mask (or other patterning device).

Although specific reference may have been made above to the use of embodiments of the invention in the context of sample assessment, it will be appreciated that the invention, where the context allows, is not limited to sample assessment and may be used in other applications, for example electron beam lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Specific embodiments of the present invention are described in the following numbered clauses:
1. An assessment apparatus for assessing a sample, the assessment apparatus comprising:
   a sample holder for holding the sample;
   an electron-optical device for directing a charged particle beam on to the sample; and
   a detector module for detecting signal particles from the sample in response to the charged particle beam;
   wherein the electron-optical device comprises a quantum sensor configured to measure a physical field in the assessment apparatus.
2. The assessment apparatus of clause 1, wherein the physical field is a magnetic field.
3. The assessment apparatus of clause 1 or 2, wherein the physical field is an electric field.
4. The assessment apparatus of any one of clauses 1 to 3, wherein the quantum sensor comprises a nitrogen-vacancy diamond sensor or an atomic vapor cell.
5. The assessment apparatus of any one of clauses 1 to 4, wherein the quantum sensor is configured to output a scalar measurement of field strength.
6. The assessment apparatus of any one of clauses 1 to 4, wherein the quantum sensor is configured to output a measurement of field strength in a specific direction.
7. The assessment apparatus of clause 6, wherein there are a plurality of quantum sensors configured to output measurements of field strength in respective directions.
8. The assessment apparatus of any one of clauses 1 to 4, wherein the quantum sensor is configured to output a vector measurement of field strength.
9. The assessment apparatus of any one of clauses 1 to 8, wherein the electron-optical device comprises one or more quantum sensors located near one or more of:
   a source;
   a beam aperture;
   a condenser lens array or macro condenser lens;
   a collimator array or macro collimator; and
   an objective lens or objective lens array.
10. The assessment apparatus of any one of clauses 1 to 9, wherein the electron-optical device is a multi-beam electron-optical device having a plurality of beam paths and the electron-optical device comprises a plurality of quantum sensors distributed across a plane perpendicular to the beam paths.
11. The assessment apparatus of clause 10, further comprising a controller configured to determine information of beam currents in individual ones of the plurality of beam paths based on signals output by the plurality of quantum sensors.
12. The assessment apparatus of any one of clauses 1 to 11, wherein the quantum sensor has a sampling rate greater than 1 Hz, desirably between 100 and 500 Hz.
13. The assessment apparatus of any one of clauses 1 to 11, wherein the quantum sensor has a sampling rate greater than 5 times the repetition rate of the charged particle beam.
14. The assessment apparatus of any one of clauses 1 to 13, wherein the quantum sensor has a sensitivity of less than 20 nT/sqrt(Hz) or 10 mV/m.
15. The assessment apparatus of any one of clauses 1 to 14, further comprising an electromagnet, desirably a Helmholtz coil, surrounding the quantum sensor.
16. The assessment apparatus of any one of clauses 1 to 15, further comprising a controller configured to modify an operating parameter of the assessment apparatus in response to a measurement of the quantum sensor.
17. The assessment apparatus of clause 16, wherein the controller comprises a feedback controller configured to modify an operating parameter during assessment of a single sample.
18. The assessment apparatus of clause 16 or 17, wherein the controller comprises a feedforward controller configured to modify an operating parameter during assessment of a subsequent sample.
19. The assessment apparatus of any one of clauses 16 to 18, wherein the controller comprises a calibration controller configured to modify an operating parameter during a calibration process.
20. The assessment apparatus of any one of clauses 1 to 19, further comprising an image processor configured to process an image of the sample based on measurements of the quantum sensor.
21. An assessment method comprising:
   directing a charged particle beam to a sample using an electron-optical device;
   using a quantum sensor located in the electron-optical device to measure a physical field, e.g. an electrical or magnetic field.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

### LISTING OF DRAWING ELEMENTS

100 assessment apparatus
110 vacuum chamber (main chamber)
120 load lock chamber
124 gun aperture
125 beam limit aperture
130 EFEM
130a first loading port
130b second loading port
132a pole piece
132b control electrode
132c deflector
132d exciting coil
135 column aperture
140 electron-optical apparatus (electron beam apparatus, electron apparatus)
148 first multipole lens
150 controller
158 second multipole lens
201 source
202 source beam
204 electron-optical axis
207 sample holder
208 sample
209 actuatable stage
211, 212, 213 primary beams (sub-beams, beamlets)
220 source converter (micro-optical array)
223 pre-bending deflector array
224 aberration reduction array
230 electron-optical device (electron-optical column)
231 condenser lens array
240 detector array
241 objective lens array
242 beam shaper array
243 objective lens
250 control lens array
252 beam limiting aperture array
260 scan deflector array
261 plate
264 detector substrate
265 detector elements
266 beam apertures
267 logic layer
268 wiring layer
269 through-substrate vias
270 macro collimator
271 collimator array
272 Coulomb aperture array
273 intermediate focus plane
274 macro condenser lens
275 macro scan deflector
281-283 probe spots
291 photon converter array
292 fluorescent strip
293 openings
295 deflector array
296 magnetic deflector
297 electrostatic deflector
298 optical fiber
299 electron-optical device array

## Claims

1. An assessment apparatus for assessing a sample, the assessment apparatus comprising:
a sample holder for holding the sample;
an electron-optical device for directing a charged particle beam on to the sample; and
a detector module for detecting signal particles from the sample in response to the charged particle beam;
wherein the electron-optical device comprises a quantum sensor configured to measure a physical field in the assessment apparatus.

2. The assessment apparatus of claim 1, wherein the quantum sensor comprises a nitrogen-vacancy diamond sensor or an atomic vapor cell.

3. The assessment apparatus of claim 1, wherein the quantum sensor is configured to output a scalar measurement of field strength.

4. The assessment apparatus of claim 1, wherein the quantum sensor is configured to output a measurement of field strength in a specific direction.

5. The assessment apparatus of claim 1, wherein the quantum sensor is configured to output a vector measurement of field strength.

6. The assessment apparatus of claim 1, wherein the electron-optical device comprises one or more quantum sensors located near one or more of:
a source;
a beam aperture;
a condenser lens array or macro condenser lens;
a collimator array or macro collimator; and
an objective lens or objective lens array.

7. The assessment apparatus of claim 1, wherein the electron-optical device is a multi-beam electron-optical device having a plurality of beam paths and the electron-optical device comprises a plurality of quantum sensors distributed across a plane perpendicular to the beam paths.

8. The assessment apparatus of claim 1, wherein the quantum sensor has a sensitivity of less than 20 nT/sqrt(Hz) or 10 mV/m.

9. The assessment apparatus of claim 1, further comprising an electromagnet, desirably a Helmholtz coil, surrounding the quantum sensor.

10. The assessment apparatus of claim 1, further comprising a controller configured to modify an operating parameter of the assessment apparatus in response to a measurement of the quantum sensor.

11. The assessment apparatus of claim 10, wherein the controller comprises a feedback controller configured to modify an operating parameter during assessment of a single sample.

12. The assessment apparatus of claim 10, wherein the controller comprises a feedforward controller configured to modify an operating parameter during assessment of a subsequent sample.

13. The assessment apparatus of claim 10, wherein the controller comprises a calibration controller configured to modify an operating parameter during a calibration process.

14. The assessment apparatus of claim 1, further comprising an image processor configured to process an image of the sample based on measurements of the quantum sensor.

15. An assessment method comprising:
directing a charged particle beam to a sample using an electron-optical device;
using a quantum sensor located in the electron-optical device to measure a physical field, e.g. an electrical or magnetic field.
